# DEMANDE DE BREVET EUROPEEN

(11) **EP 2 333 815 A1**
(43) Date de publication de la demande: **15.06.2011**
(21) Numéro de dépôt: 10187969.0
(22) Date de dépôt: 19.10.2010
(51) Int. Cl.: H01L 21/02, H01L 21/762

(54) **Procédé de détourage d'un substrat chanfreiné.**

(30) Priorité: 11.12.2009 FR 0958882
(71) Demandeur: S.O.I. Tec Silicon on Insulator Technologies, 38190 Bernin (FR)
(72) Inventeur: Schwarzenbach, Walter, 38330, SAINT NAZAIRE LES EYMES (FR); Alami-Idrissi, Aziz, 38660, LE TOUVET (FR); Chibko, Alexandre, 38330, SAINT NAZAIRE LES EYMES (FR); Kerdiles, Sébastien, 38330, SAINT-ISMIER (FR)
(74) Mandataire: Bomer, Françoise Marie

(57) **Abrégé**

L'invention concerne un procédé de détourage d'un substrat chanfreiné (4).

Ce procédé est remarquable en ce qu'il comprend les étapes suivantes consistant à :
- déposer une couche d'un matériau de protection sur une zone annulaire périphérique dudit substrat (4), à l'aide d'un plasma,
- réaliser une gravure partielle dudit matériau de protection à l'aide d'un plasma, de façon à n'en conserver qu'un anneau (60) sur la face avant (41) dudit substrat (4), cet anneau (60) s'étendant à distance du bord (43) du substrat, et à définir ainsi une zone annulaire périphérique accessible (400'),
- graver à l'aide d'un plasma, une épaisseur du matériau constituant ledit substrat à détourer (4), au niveau de ladite zone annulaire périphérique accessible (400') du substrat (4),
- retirer ledit anneau de matériau de protection (60) à l'aide d'un plasma.

Applications dans le domaine de l'électronique, l'optique ou l'optoélectronique.

## Description

L'invention se situe d'une manière générale dans le domaine de la fabrication des substrats destinés à des applications dans les domaines de l'électronique, l'optique ou l'optoélectronique.

Parmi les différents procédés de fabrication utilisés, on peut citer ceux utilisant des étapes de collage et de transfert de couche. Un exemple d'un tel procédé est décrit ci-après.

Conformément à ce procédé, un premier substrat, dit "donneur", éventuellement recouvert d'une couche d'isolant qui l'encapsule, est soumis à une implantation d'espèces atomiques et/ou ioniques en vue de créer en son sein, une zone de fragilisation. Ce substrat est ensuite collé par adhésion moléculaire à un second substrat, dit "receveur", puis le substrat donneur est séparé en deux parties le long de cette zone de fragilisation, de sorte que l'on transfert sur le substrat receveur, une épaisseur voulue du matériau du substrat donneur et éventuellement la couche d'isolant si cette dernière est présente.

A l'issue de ce transfert, le substrat donneur est devenu un reliquat appelé "négatif", tandis que le substrat receveur est devenu un substrat multicouche, dénommé "positif".

Un tel procédé de transfert de couche permet notamment de fabriquer des substrats connus sous l'acronyme de "SOI", d'après la terminologie anglaise de *"Silicon On Insulator"* qui signifie "silicium sur isolant", et ce, à un coût compétitif, à condition toutefois que le substrat donneur puisse être recyclé.

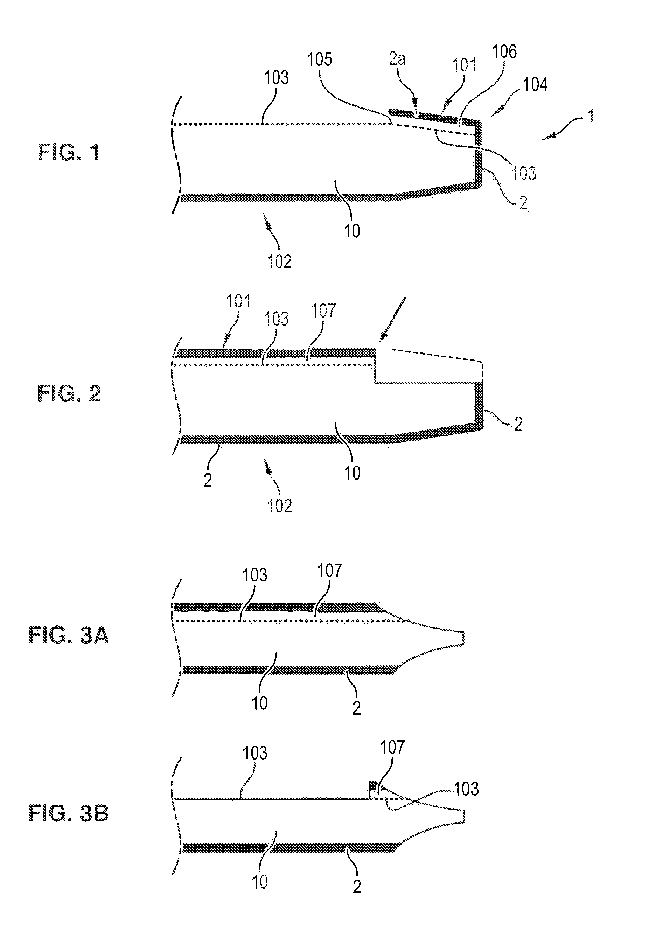

La figure 1 jointe représente, de façon schématique et en coupe transversale, la forme d'une partie (ici le côté droit) d'un exemple de négatif obtenu à l'issue d'un premier transfert de couche. C'est ce négatif qui doit être recyclé, afin de constituer de nouveau un substrat donneur utilisable dans un procédé de fabrication tel que décrit précédemment.

Sur cette figure, on peut voir un négatif référencé d'une manière générale 1 et qui comprend un substrat donneur 10 présentant une face 101, dite "avant" car étant celle qui a été en contact avec le substrat receveur, et une face opposée 102, dite "arrière".

Le substrat donneur 10 est chanfreiné au niveau d'une zone périphérique annulaire tant sur sa face avant que sur sa face arrière. Il était initialement intégralement recouvert d'une couche d'isolant 2, mais après le détachement de la couche de matériau s'étendant dans la partie non chanfreinée du substrat, entre la face avant 101 et une zone de fragilisation 103, on observe que le négatif comprend une couronne annulaire non transférée 104.

Cette couronne non transférée 104 s'étend entre la limite 105 du détachement et le bord extérieur du substrat ou en d'autres termes, en regard de la zone chanfreinée implantée. Cette couronne non transférée 104 comprend une portion d'isolant 2a et une portion de silicium 106. Elle peut atteindre par exemple une épaisseur de plusieurs centaines de nanomètres et une largeur de l'ordre de 1 à 3 mm. Sa présence est liée au fait que la portion chanfreinée du substrat donneur n'adhère pas suffisamment au substrat receveur et n'est donc pas transférée.

Le recyclage effectué selon les techniques de l'art antérieur consiste à :
- éliminer la totalité de l'isolant 2, c'est-à-dire tant l'isolant 2a que celui présent en face arrière et sur le bord,
- éliminer la couronne résiduelle 106 de silicium pour supprimer le profil en forme de marche,
- retirer sur tout le côté avant du substrat, une épaisseur de silicium correspondant au moins à l'épaisseur endommagée par l'implantation,
- réaliser un polissage de la face avant dudit négatif, de façon à retrouver un état de surface dénommé "poli miroir", par exemple en pratiquant un polissage mécano-chimique connu de l'homme du métier sous l'acronyme "CMP", d'après l'expression anglaise *"Chemical Mechanical Polishing".*

Un tel recyclage peut par exemple être effectué selon le procédé décrit dans le document EP 1 156 531, qui consiste à effectuer une étape de désoxydation du négatif, par exemple par gravure dans un bain d'acide, une étape de meulage de l'extrême bord de la plaque et enfin une étape de polissage de la surface implantée.

En pratique, il se trouve que les équipements qui retirent uniquement de la matière sur la face avant du substrat ne permettent pas de retirer une épaisseur régulière. De ce fait, on utilise de préférence des équipements qui réalisent un polissage double face du négatif, ce qui aboutit à un retrait de matière de près de 5 µm sur chaque face du substrat donneur.

Les procédés de recyclage précités présentent de nombreux inconvénients, à savoir notamment :
- un coût important en raison de la présence d'au moins deux, voire trois étapes de polissage qui nécessitent des équipements chers, volumineux et difficiles à entretenir et une forte consommation de produits consommables tels que des liquides de polissage et des tissus de polissage *("slurries"* et *"pads"* en anglais).
- la complexité du procédé.
- l'enlèvement important de matière à chaque recyclage, de l'ordre de 10 µm, ce qui conduit rapidement, notamment après plusieurs cycles de recyclage à l'obtention de substrats trop fins et par là trop fragiles. De tels substrats ne respectent alors plus les spécifications SEMI et ne pourront donc plus être utilisés de nouveau, notamment en tant que substrats receveurs.

Enfin, un autre inconvénient réside dans le fait que la couronne annulaire implantée mais non collée se dégrade au moins partiellement lors du traitement de recuit effectué pour procéder au détachement de la couche issue du substrat donneur. Il en résulte un phénomène de bullage qui produit de très nombreuses particules qui peuvent contaminer non seulement le positif mais également les équipements utilisés ultérieurement pour différents traitement de ces plaques et en particulier les équipements de nettoyage après décollement.

Le document WO 2005/038903, décrit le transfert d'une couche active par assemblage de deux plaques chanfreinées. Afin d'éviter qu'un bord de plaque non collé ne se casse de façon incontrôlée et n'induise la présence de particules sur les autres surfaces, il est suggéré d'éliminer une zone de bord de la couche active. Comme cette étape est très délicate, le document W02005/038903 propose d'effectuer un détourage dans une portion périphérique d'une des plaques avant de coller les deux plaques entre elles.

La figure 2 jointe représente, de façon schématique et en coupe transversale, la forme qu'une partie (ici le côté droit) d'un substrat donneur de type SOI présenterait en théorie après avoir subi le traitement de détourage avant collage décrit dans le document WO2005/038903.

Les éléments identiques à ceux de la figure 1 portent les mêmes références numériques.

Comme on peut le voir, il a été procédé au retrait de la couche d'isolant 2 et d'une partie de la couche de matériau du substrat donneur 10 dans une zone annulaire périphérique s'étendant sur la face avant, sur une largeur correspondant au minimum à celle de la zone chanfreinée et sur une épaisseur au moins égale à la profondeur de la zone d'implantation. La couche active délimitée par la zone de fragilisation porte la référence 107.

Ce retrait est effectué par exemple par gravure.

Toutefois, les solutions proposées dans le document précité W02005/038903 pour effectuer le détourage ne permettent pas d'obtenir un rebord aussi abrupt, c'est-à-dire aussi perpendiculaire à la face avant que représenté sur la figure 2.

En effet, des essais effectués par la demanderesse en utilisant la solution consistant à graver successivement les couches d'oxyde de silicium puis de silicium à l'aide d'un plasma ont montrés que le détourage obtenu présente une pente faible comme représenté sur la figure 3A jointe. On continue, entre autres, à graver l'oxyde de silicium pendant l'étape de gravure du silicium.

De plus, et comme on peut le voir sur la figure 3B, le négatif obtenu conserve une couronne non transférée incluant une couche d'oxyde et une couche de silicium implanté, ce qui obère sensiblement les avantages attendus du procédé de détourage pour le futur recyclage du négatif.

Enfin, l'autre solution de détourage proposée dans le document WO2005/038903 consiste :
- à protéger le substrat positif traité par un dépôt de couche protectrice (par exemple d'oxyde), puis à en retirer une couronne périphérique annulaire par lithographie,
- à procéder au détourage par gravure de la couche non protégée dudit positif,
- à retirer ensuite le dit masque protecteur.

Toutefois, l'emploi d'une étape supplémentaire de formation d'un masque de protection accroit les coûts et surtout est une source de contamination. Or, il est préférable d'éviter d'apporter des impuretés avant le collage, puisque l'on souhaite réduire la défectivité des substrats obtenus.

L'invention a pour but de résoudre les inconvénients précités de l'état de la technique.

L'invention a notamment pour objectif de fournir un procédé de détourage d'un substrat chanfreiné, muni d'une zone de fragilisation, qui permette d'obtenir un bord détouré franc, c'est-à-dire perpendiculaire ou quasiment perpendiculaire à la face avant plane dudit substrat, et ce, sans augmenter la défectivité dudit substrat.

Un autre objectif de l'invention est d'offrir un tel procédé qui n'augmente pas les coûts de fabrication et qui puisse s'intégrer facilement dans les chaines de production couramment utilisées dans le domaine de la microélectronique.

Enfin, ce procédé de détourage doit également pouvoir être utilisé dans un procédé de transfert de couche.

A cet effet, l'invention concerne un procédé de détourage d'un substrat chanfreiné.

Conformément à l'invention, ce procédé comprend les étapes suivantes consistant à :
- déposer une couche d'un matériau de protection sur une zone annulaire périphérique dudit substrat, à l'aide d'un plasma,
- réaliser une gravure partielle dudit matériau de protection à l'aide d'un plasma, de façon à conserver un anneau de matériau de protection sur la face avant dudit substrat à détourer, cet anneau s'étendant à distance du bord du substrat, et à délimiter ainsi une zone annulaire périphérique réduite dudit substrat accessible à un plasma,
- générer un plasma de gravure partielle localisé au niveau de ladite zone annulaire périphérique accessible réduite du substrat, de façon à graver le matériau présent dans cette zone sur une certaine épaisseur,
- retirer ledit anneau de matériau de protection à l'aide d'un plasma.

Selon d'autres caractéristiques avantageuses et non limitatives de l'invention, prises seules ou en combinaison :
- les différentes étapes du procédé sont réalisées dans une enceinte de formation d'un plasma isotrope,
- ce procédé comprend les étapes consistant à :
   - introduire ledit substrat à détourer à l'intérieur d'une enceinte de formation d'un plasma isotrope, équipée d'un élément supérieur isolant en forme de disque et de deux électrodes, l'une d'entre elle, dite "inférieure" étant entourée d'un élément inférieur isolant de contour circulaire, ledit substrat étant disposé dans ladite enceinte de sorte que sa face arrière soit au contact de ladite électrode inférieure et dudit élément isolant inférieur, de façon à définir une zone d'exclusion en face arrière, non accessible au plasma et l'isolant supérieur étant positionné à distance de la face avant dudit substrat, de façon à définir une zone d'exclusion en face avant également non accessible au plasma, les diamètres extérieurs des deux éléments isolants, inférieur et supérieur, étant inférieurs au diamètre du substrat à détourer, le reste du substrat constituant ladite zone annulaire périphérique,
   - déposer ladite couche d'un matériau de protection sur la dite zone annulaire périphérique, à l'aide d'un plasma formé dans ladite enceinte,
   - rapprocher l'isolant supérieur de la face avant dudit substrat et réaliser ladite gravure partielle du matériau de protection,
   - tout en maintenant l'isolant supérieur dans sa position, graver une épaisseur du matériau constituant ledit substrat à détourer,
   - écarter l'isolant supérieur de la face avant dudit substrat et retirer ledit anneau de matériau de protection,
      - ledit matériau de protection est un polymère,
      - le matériau de protection est du polyéthylène, obtenu par un plasma à base de C₂H₄,
      - le plasma de gravure du matériau de protection ou de retrait de ce matériau de protection est un plasma à base d'oxygène,
      - le substrat à détourer est en silicium et le plasma de gravure à base d'un mélange de SF6 et d'argon,
      - le substrat à détourer est recouvert d'une couche d'oxyde de silicium et le plasma de gravure à base d'un mélange de CHF₃ et d'azote,
      - le substrat à détourer est en silicium recouvert d'une couche d'oxyde de silicium et en ce que l'on effectue successivement la gravure de la couche d'oxyde de silicium puis la gravure d'une épaisseur de la couche de silicium,
      - le substrat à détourer comprend une zone de fragilisation qui s'étend dans un plan parallèle ou sensiblement parallèle à sa face avant et en ce que la gravure partielle du matériau de protection est conduite de façon que le diamètre extérieur de l'anneau de matériau de protection ainsi formé soit inférieur ou égal à celui de la zone plane non chanfreinée de ladite face avant, de façon à graver le matériau constituant ledit substrat à détourer sur une largeur correspondant au moins à la totalité de ladite zone chanfreinée,
      - le diamètre de l'isolant supérieur est inférieur ou égal à celui de la zone plane non chanfreinée de la face avant du substrat à détourer,
      - le substrat à détourer comprend une zone de fragilisation qui s'étend dans un plan parallèle ou sensiblement parallèle à sa face avant et en ce qu'il est gravé sur une épaisseur correspondant à celle de ladite zone de fragilisation,

L'invention concerne également un procédé de fabrication d'un substrat destiné à des applications dans le domaine de l'électronique, l'optique ou l'optoélectronique.

Ce procédé comprend les étapes suivantes :
- former une zone de fragilisation à l'intérieur d'un substrat donneur, de façon à y délimiter une couche à transférer du reste du substrat,
- soumettre ce substrat donneur à un procédé de détourage tel que celui décrit précédemment,
- coller par adhésion moléculaire le substrat donneur ainsi détouré, sur un substrat receveur,
- effectuer un traitement de détachement de ladite couche à transférer le long de ladite zone de fragilisation, de façon à la transférer sur ledit substrat receveur,

Selon une variante, ladite zone de fragilisation est formée par implantation d'espèces atomiques et/ou ioniques.

D'autres caractéristiques et avantages de l'invention apparaîtront de la description qui va maintenant en être faite, en référence aux dessins annexés, qui en représentent, à titre indicatif mais non limitatif, un mode de réalisation possible.

Sur ces dessins, outre ceux précédemment décrits :
- les figures 4A et 4B représentent de façon schématique et en coupe transversale, respectivement les extrémités droites d'un substrat donneur ayant subi le procédé de détourage conforme à l'invention, collé sur un substrat receveur et ces deux mêmes substrats après l'étape de détachement,
- les figures 5A et 5B sont des graphiques représentant le profil en coupe transversale de l'oxyde d'un substrat détouré, en fonction du rayon R de ce substrat exprimé en mm, respectivement avec un procédé de l'art antérieur et avec le procédé conforme à l'invention.
- les figures 6A à 6D sont des schémas représentant en coupe transversale partielle le substrat à détourer et l'installation permettant la mise en oeuvre du procédé de détourage de l'invention, respectivement au cours des différentes étapes successives du procédé.

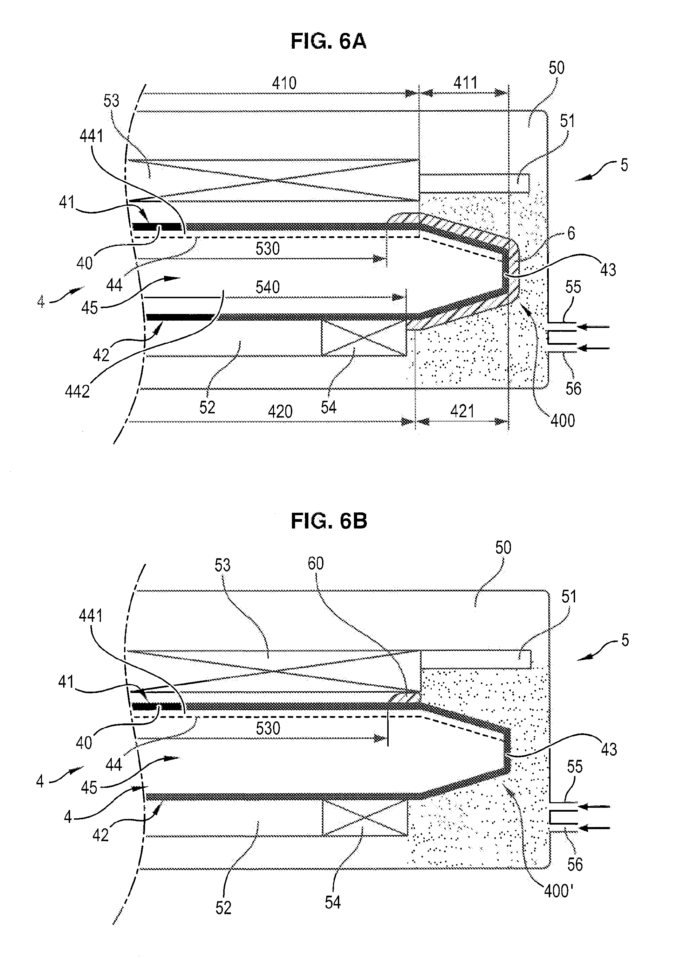

Un mode de réalisation préférentiel du procédé de détourage conforme à l'invention va maintenant être décrit en liaison avec les figures 6A à 6D.

On va tout d'abord décrire le substrat à détourer en se reportant à la figure 6A.

Le schéma n'est pas représentatif de l'échelle réelle du substrat par rapport à l'installation. De même, les proportions du substrat ont été modifiées pour faciliter l'explication.

Sur cette figure, on peut voir un substrat à détourer qui porte la référence générale 4 et qui présente une face avant 41, une face opposée arrière 42 et un rebord latéral 43;

Ce substrat 4 est chanfreiné, de sorte que sa face avant 41 se décompose en une zone centrale plane non chanfreinée 410 et une zone chanfreinée 411 et que, de même, sa face arrière 42 se décompose en une zone plane non chanfreinée 420 et une zone chanfreinée 421.

Dans l'exemple de réalisation représenté, le substrat 4 est constitué par un substrat 45 recouvert sur la totalité de sa surface extérieure d'une couche d'isolant 40. Toutefois, cette dernière caractéristique n'est pas obligatoire.

Le procédé de détourage peut s'appliquer à tout type de substrat, néanmoins il trouve une application particulière dans le détourage d'un substrat muni d'une zone de fragilisation, ce substrat étant destiné à être utilisé ultérieurement dans un procédé de collage et de transfert de couche.

La zone de fragilisation porte la référence 44. Elle permet de délimiter une couche active 441 qui s'étend jusqu'à la face avant 41, du reste 442 du substrat.

De façon avantageuse, cette zone de fragilisation 44 est formée par implantation d'espèces atomiques et/ou ioniques selon le procédé d'implantation développé en liaison avec la technique connue de l'homme du métier sous la dénomination "Smart cut".

Cette zone de fragilisation 44 pourrait également être constituée d'une couche poreuse.

Le procédé de détourage de l'invention peut être réalisé par exemple, à l'intérieur d'un réacteur 5 de formation de plasma, tel que celui représenté sur les figures 6A à 6D.

Ce réacteur comprend une enceinte 50, à l'intérieur de laquelle sont installés deux éléments isolants 53, 54 et deux électrodes 51, 52, ces dernières étant reliées à une alimentation électrique non représentée sur les figures.

Le substrat à détourer 4 repose sur l'électrode inférieure 52 et l'élément isolant inférieur 54, par sa face arrière 42.

L'électrode inférieure 52 est entourée par l'élément inférieur isolant 54 de contour circulaire. De préférence, l'électrode 52 est circulaire et l'élément isolant 54 est annulaire.

Par ailleurs, l'isolant supérieur 53 présente la forme d'un disque et l'électrode 51 qui l'entoure est de forme annulaire.

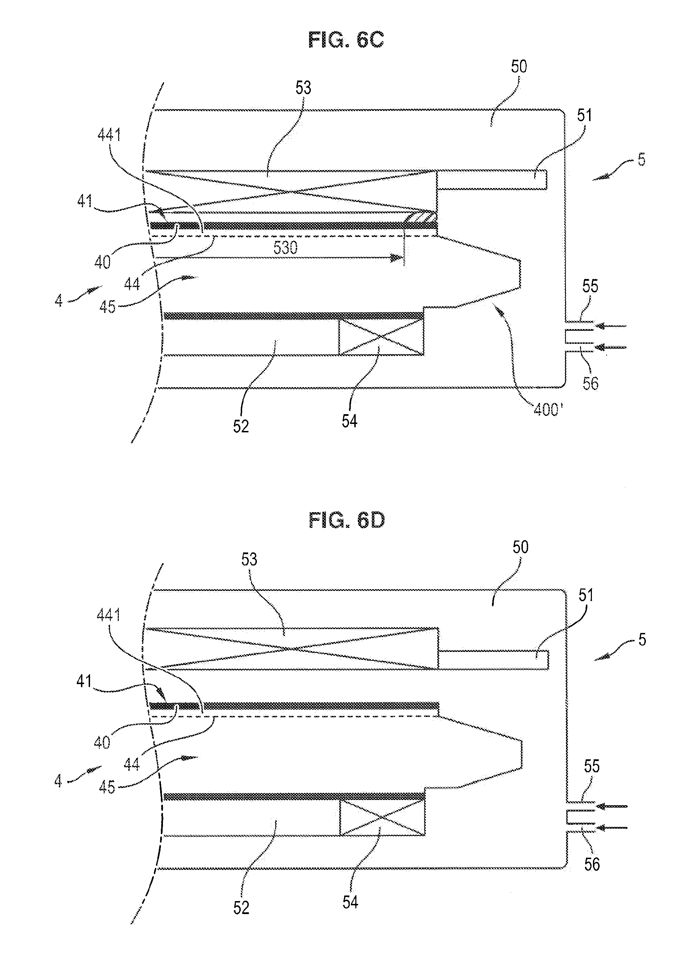

L'élément isolant supérieur 53 est monté sur des moyens moteurs, non représentés sur les figures, qui permettent son déplacement selon un axe vertical perpendiculaire au plan médian du substrat 4. Il peut ainsi être déplacé entre une position représentée sur la figure 6D, dans laquelle il est écarté au maximum du substrat 4 à détourer et une position représentée sur les figures 6B et 6C, dans laquelle il est rapproché de ce substrat 4.

Les gaz utilisés pour la formation du plasma sont introduits à l'intérieur de l'enceinte 50 via des canalisations, par exemple ici au nombre de deux, référencées 55 et 56.

Les matériaux volatils, produits lors de la réaction qui se déroule à l'intérieur de l'enceinte 50, peuvent être évacués hors de celle-ci par des moyens d'aspiration et un orifice non représentés sur les figures.

Les électrodes 51 et 52 sont mises sous tension, ce qui a pour effet de créer un champ électrique à l'intérieur de l'enceinte 50 et de transformer les gaz introduits dans les canalisations 55 et 56 en un plasma.

Différents paramètres, tels que la température et la pression régnant à l'intérieur de l'enceinte 50, la nature, le débit et les ratios des gaz introduits à l'intérieur de l'enceinte 50, la fréquence du plasma, ainsi que la tension (ou la puissance) appliquée aux bornes des électrodes 51 et 52 ont une incidence sur la composition chimique du plasma formé et sur sa nature, à savoir un plasma de dépôt ou un plasma de gravure. Ces paramètres seront détaillés ci-après.

De préférence, le plasma formé tant pour le dépôt que pour la gravure est isotrope. Ceci signifie que de préférence l'action du plasma est réalisée par le biais de radicaux créés dans le plasma, et éventuellement pourrait être réalisée par le biais d'ions accélérés dans la gaine du plasma.

Le fait que la face arrière 42 du substrat 4 soit au contact de l'électrode inférieure 52 et de l'isolant inférieur 54, permet de définir une zone d'exclusion en face arrière, référencée 540, non accessible au plasma, car masquée.

Comme on peut le voir sur les figures, le diamètre extérieur de l'isolant 54 correspond exactement au diamètre de la zone d'exclusion en face arrière 540 puisque le substrat 4 à détourer est directement au contact de l'isolant 54.

En outre, le substrat à détourer 4 est bien évidemment disposé de façon à être centré par rapport à l'isolant annulaire 54.

Par ailleurs, l'isolant supérieur 53 permet également de définir sur la face avant 41 du substrat, une zone dite "d'exclusion en face avant" 530, non accessible au plasma.

Le diamètre de la zone d'exclusion en face avant 530 dépend non seulement du diamètre de l'isolant supérieur 53, mais également de son écartement par rapport au substrat à détourer 4. Ainsi, plus l'isolant 53 est écarté de la face avant 41 du substrat et plus la zone d'exclusion en face avant 530 présente un faible diamètre (voir figure 6A), et inversement, plus il s'en rapproche et plus le diamètre de cette zone 530 est grand (voire figure 6B).

La zone périphérique annulaire du substrat 4 qui reste accessible au plasma, c'est-à-dire la zone qui s'étend hors des zones 530 et 540 précitées, est référencée 400. En d'autres termes, cette zone annulaire périphérique 400 comprend le rebord 43 du substrat, les zones chanfreinées 411 et 421 et éventuellement une partie de la périphérie des faces avant 41 et arrière 42.

Les différentes étapes du procédé de détourage vont maintenant être décrites.

Après que le substrat à détourer 4 a été introduit dans l'enceinte 5, de façon que sa face arrière 42 repose contre l'élément isolant 54 et l'électrode inférieure 52, les paramètres de formation du plasma sont réglés de façon à déposer sur ladite zone annulaire accessible 400, une couche d'un matériau de protection 6.

De préférence, ce matériau de protection 6 est un polymère.

De préférence encore, il s'agit de polyéthylène obtenu à l'aide d'un plasma à base d'éthylène C₂H₄.

On rapproche ensuite l'isolant supérieur 53 de la face avant 41 du substrat 4, de façon à agrandir la zone d'exclusion en face avant 530 et à en augmenter le diamètre. On notera que l'isolant 53 n'est jamais amené au contact de la face supérieure 41 du substrat, de façon à éviter d'endommager celle-ci ou de la contaminer.

Dans cette position, illustrée sur la figure 6B, les paramètres du plasma sont adaptés, de façon à réaliser une gravure partielle du matériau de protection 6. Cette gravure est partielle, de sorte qu'elle permet de conserver uniquement un anneau 60 de matériau de protection sur la face avant 41 du substrat 4.

Cette gravure partielle est possible du fait de l'agrandissement de la zone d'exclusion en face avant 530. Dans la position de l'isolant 53 représenté sur la figure 6A, la zone où se trouve l'anneau 60 est accessible par le plasma et le matériau de protection 6 a pu y être déposé. En revanche, lorsque l'isolant 53 est abaissé, la portion du matériau de protection correspondant à l'anneau 60 n'est plus accessible par le plasma et de ce fait n'est pas gravée par celui-ci. En d'autres termes, lorsque l'aire de la zone d'exclusion en face avant 530 augmente, celle de la zone accessible 400 diminue. La zone accessible réduite porte la référence 400'.

La nature du plasma de gravure du matériau de protection 6 est bien évidemment fonction de la nature chimique de ce matériau.

A titre d'exemple, pour un matériau de protection en polyéthylène, la gravure s'effectue à l'aide d'un plasma à base d'oxygène, (O₂).

L'étape suivante est illustrée sur la figure 6C. Tout en maintenant l'isolant supérieur 53 dans la position représentée sur la figure 6B, la nature des gaz introduits à l'intérieur de l'enceinte 50 est modifiée de façon à créer un plasma apte à graver une épaisseur du matériau constituant le substrat à détourer 4. Cette gravure ne s'effectue qu'au niveau de la zone annulaire périphérique du substrat accessible au plasma 400', compte tenu de la présence de l'anneau 60.

Dans le cas particulier où une couche d'isolant 40 est présente, et notamment s'il s'agit d'une couche d'oxyde, le plasma de gravure sera alors à base d'un mélange d'azote et de CHF₃ (trifluorométhane).

Lorsque l'isolant 40 a été entièrement gravé dans la zone accessible résiduelle 400', les gaz introduits dans l'enceinte sont modifiés de façon à procéder à la gravure du matériau constituant le substrat 45.

A titre d'exemple, lorsque le matériau constituant le substrat 45 est du silicium, le plasma de gravure à base d'un mélange d'argon et de SF₆ (hexafluorure de soufre) et éventuellement d'azote.

Comme représenté sur la figure 6C, on obtient un substrat 4 détouré à sa périphérie non seulement sur sa face avant, sa face arrière mais également son côté.

A titre d'exemple illustratif et notamment pour des applications au collage et transfert de couches, la partie détourée s'étend sur une largeur de l'ordre de 0.5 à 3 mm depuis le bord de la plaque, de préférence de 1 à 2 mm, idéalement 1.2 mm. La profondeur du détourage correspond à l'épaisseur de transfert après collage. Elle comprend donc l'épaisseur de la couche d'isolant 40 si celui-ci est présent (typiquement voisine de 1500 Å (150 nm), plus largement comprise entre 100 & 4000 Å (10 nm et 400 nm) ainsi que l'épaisseur de la couche de substrat que l'on souhaite transférer ultérieurement, soit typiquement pour la fabrication d'un SOI entre 1000 et 10.000 Å (100 et 1000 nm), de préférence de l'ordre 2500 Å (250 nm).

Enfin, comme représenté sur la figure 6D, on écarte ensuite l'isolant supérieur 53 de la face avant 41 du substrat 4 et l'on modifie les paramètres du plasma de façon à créer un plasma de gravure permettant le retrait de l'anneau 60 de matériau de protection. Ce plasma de gravure est généralement le même que celui utilisé dans l'étape de gravure représentée sur la figure 6B.

Pour toutes les étapes qui viennent d'être décrites et qui concernent l'emploi d'un plasma de dépôt ou d'un plasma de gravure, la fréquence conventionnelle du plasma est de 13.56 MHz. La puissance est de l'ordre de 100 à 500 W. La durée d'application du plasma varie entre 5 et 40 secondes. La combinaison de la puissance et de la durée du plasma induit notamment un effet sur l'épaisseur gravée. Enfin, la pression à l'intérieur de l'enceinte est de l'ordre de quelques Torr (1 Torr étant égal à environ 10² Pa).

Lorsque le substrat à détourer comprend une zone de fragilisation 44, le diamètre de l'isolant 53 et sa position seront avantageusement déterminés de façon que le diamètre extérieur de l'anneau 60 corresponde à celui de la zone plane avant non chanfreiné 410.

Ainsi, il est impossible de graver le substrat 4 uniquement sur la partie chanfreinée 411 de sa face avant.

Le diamètre extérieur de l'anneau 60 de la couche de protection pourrait toutefois être inférieur à celui représenté sur les figures, c'est-à-dire que la position de l'anneau 60 serait déplacée sur la gauche des figures. Cependant, ceci aboutirait à la gravure également d'une portion de la zone plane avant non chanfreinée 410, ce qui serait moins avantageux économiquement.

Cette façon de procéder permet d'être sûr que la totalité de la zone chanfreinée 411 de la face avant et ayant subie l'implantation est retirée. On limite ainsi le risque de contaminations ultérieures évoquées précédemment.

De façon avantageuse également, la couche de matériau du substrat 4 gravée correspond à l'épaisseur de matériau qui s'étend entre la face avant et la zone de fragilisation 44.

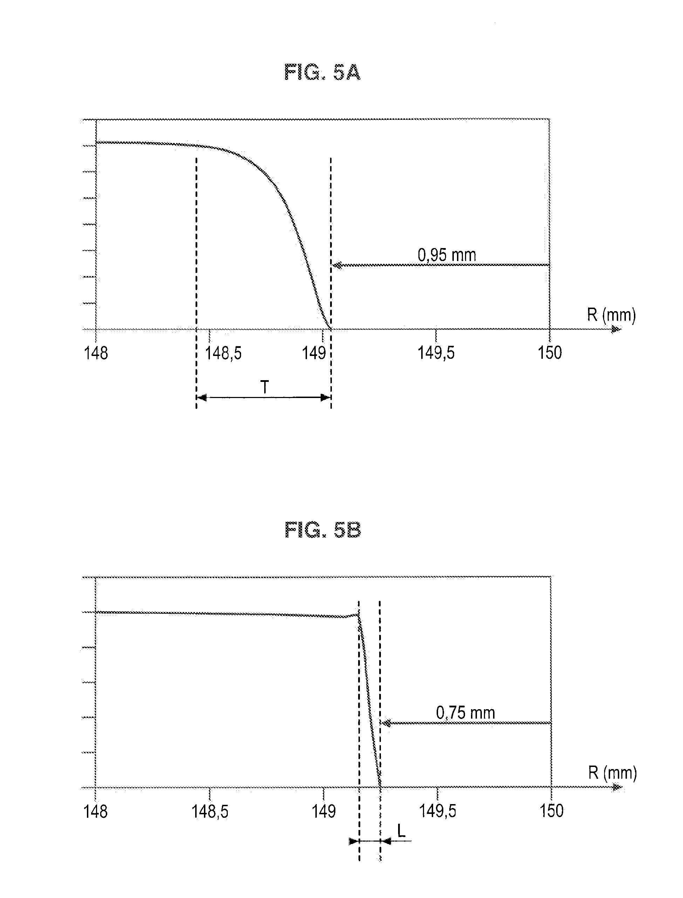

Après détourage, on obtient un substrat à bord franc, tel que celui représenté sur la figure 5B. En d'autres termes, la largeur de la zone de transition T entre la partie non détourée du substrat située sur la gauche de la figure et la partie détourée située sur la droite est faible.

A titre de comparaison, la figure 5A illustre le résultat obtenu avec un procédé de détourage de l'art antérieur, selon lequel on a effectué une première gravure par plasma de la couche d'oxyde suivie d'une deuxième gravure par plasma de la couche de silicium, mais sans application d'un dépôt annulaire de protection. La pente de la gravure est dans ce cas dégradée, d'une part car la gravure de l'oxyde n'est pas limitée par une couche de protection, d'autre part car la sélectivité n'étant pas parfaite, la gravure du silicium induit également une légère gravure de l'oxyde. On constate aisément que dans ce cas, la zone de transition T entre les parties respectivement détourée et non détourée du substrat est beaucoup plus large. On se trouve alors dans la situation représentée sur la figure 3A.

Au vu des deux exemples précités, on constate que le procédé conforme à l'invention permet de réduire la largeur de cette zone de transition T d'un facteur 10 environ.

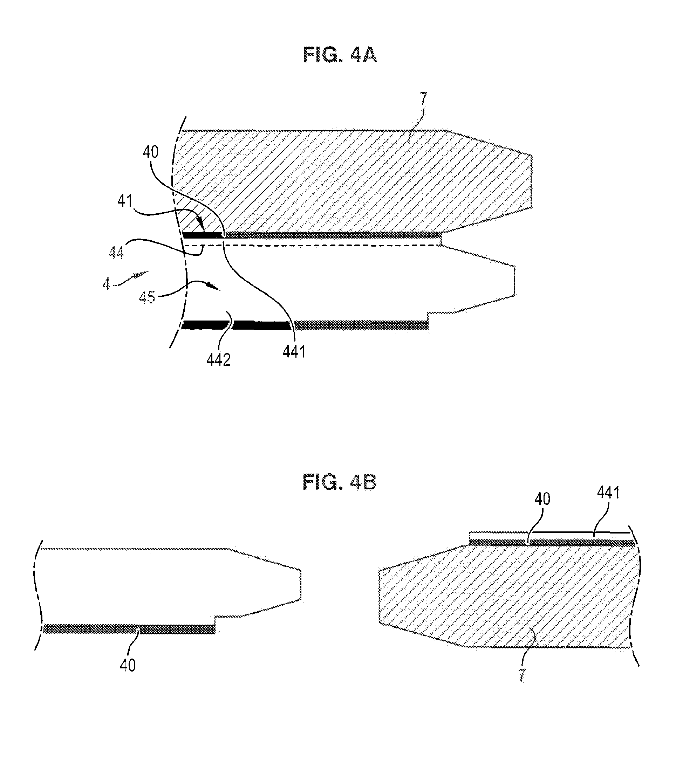

Les figures 4A à 4B illustrent les différentes étapes d'un procédé de fabrication d'un substrat qui consiste, après avoir formé une zone de fragilisation 44 à l'intérieur d'un substrat donneur 4, à le soumettre à un procédé de détourage tel que celui décrit précédemment.

Ce substrat donneur 4 détouré est ensuite collé sur un substrat receveur 7, (voir figure 4A) puis est soumis à un traitement de détachement visant à transférer sa couche active 441 sur ledit substrat receveur 7, (voir figure 4B).

Les avantages obtenus par l'utilisation de ce procédé sont les suivants :
- le positif obtenu présente une couche active 441 bien délimitée par la limite de gravure,
- en veillant à graver une épaisseur de matériau correspondant à l'épaisseur déterminée par la profondeur d'implantation, le négatif obtenu ne présente plus de couronne non transférée. Ainsi, aucune marche n'est présente en bord de plaque, (voir partie gauche de la figure 4).
- le recyclage du négatif s'en trouve très largement simplifié et peut se limiter à une étape de CMP dont le but est de retirer la zone endommagée par l'implantation, afin de retrouver un état de surface "poli miroir",
- le recyclage est également moins couteux puisqu'il comprend moins d'étapes et consomme moins de matière première, permettant ainsi au substrat post-recyclage de rester compatible avec les normes SEMI quant à son épaisseur, même après plusieurs recyclages,
- enfin, l'étape de fracture devient par ce biais une étape beaucoup moins génératrice de particules. La couronne des substrats SOI ainsi obtenus est plus régulière (et peut même être contrôlée quant à sa largeur) et dépourvue de particules de silicium collées en bord de plaque.

Le procédé qui vient d'être décrit présente quelques similitudes avec un procédé connu de l'état de la technique sous le nom "Bosch". Toutefois, ce procédé Bosch consiste à recouvrir la face avant d'un substrat à l'aide d'un masque, puis par gravure anisotrope de ce masque, à former sur cette face avant, des motifs de l'ordre du micromètre en vue de former ultérieurement des composants électroniques ou mécano-électriques, mais en aucun cas à détourer les bords d'une plaque entière sur une largeur de 2 ou 3 mm.

## Revendications

1. Procédé de détourage d'un substrat chanfreiné (4), **caractérisé en ce qu'**il comprend les étapes suivantes consistant à :
- déposer une couche d'un matériau de protection (6) sur une zone annulaire périphérique (400) dudit substrat (4), à l'aide d'un plasma,
- réaliser une gravure partielle dudit matériau de protection (6) à l'aide d'un plasma, de façon à conserver un anneau (60) de matériau de protection sur la face avant (41) dudit substrat (4) à détourer, cet anneau (60) s'étendant à distance du bord (43) du substrat, et à délimiter ainsi une zone annulaire périphérique réduite (400') dudit substrat accessible à un plasma,
- générer un plasma de gravure partielle, localisé au niveau de ladite zone annulaire périphérique accessible réduite (400') du substrat (4), de façon à graver le matériau présent dans cette zone sur une certaine épaisseur,
- retirer ledit anneau de matériau de protection (60) à l'aide d'un plasma.

2. Procédé selon la revendication 1, **caractérisé en ce que** les différentes étapes du procédé sont réalisées dans une enceinte (50) de formation d'un plasma isotrope.

3. Procédé selon la revendication 2, **caractérisé en ce qu'**il comprend les étapes consistant à :
- introduire ledit substrat à détourer (4) à l'intérieur d'une enceinte (50) de formation d'un plasma isotrope, équipée d'un élément supérieur isolant (53) en forme de disque et de deux électrodes (51, 52), l'une d'entre elle (52), dite "inférieure" étant entourée d'un élément inférieur isolant (54) de contour circulaire, ledit substrat (4) étant disposé dans ladite enceinte (5) de sorte que sa face arrière (42) soit au contact de ladite électrode inférieure (52) et dudit élément isolant inférieur (54), de façon à définir une zone d'exclusion en face arrière (540), non accessible au plasma et l'isolant supérieur (53) étant positionné à distance de la face avant (41) dudit substrat (4), de façon à définir une zone d'exclusion en face avant (530) également non accessible au plasma, les diamètres extérieurs des deux éléments isolants, inférieur (54) et supérieur (53), étant inférieurs au diamètre du substrat à détourer (4), le reste du substrat constituant ladite zone annulaire périphérique (400),
- déposer ladite couche d'un matériau de protection (6) sur la dite zone annulaire périphérique (400), à l'aide d'un plasma formé dans ladite enceinte (50),
- rapprocher l'isolant supérieur (53) de la face avant (41) dudit substrat et réaliser ladite gravure partielle du matériau de protection (6),
- tout en maintenant l'isolant supérieur (53) dans sa position, graver une épaisseur du matériau constituant ledit substrat à détourer (4),
- écarter l'isolant supérieur (53) de la face (41) avant dudit substrat et retirer ledit anneau de matériau de protection (60).

4. Procédé selon l'une des revendications précédentes, **caractérisé en ce que** ledit matériau de protection (6) est un polymère.

5. Procédé selon la revendication 4, **caractérisé en ce que** le matériau de protection (6) est du polyéthylène, obtenu par un plasma à base de C₂H₄.

6. Procédé selon la revendication 5, **caractérisé en ce que** le plasma de gravure du matériau de protection (6) ou de retrait de ce matériau de protection est un plasma à base d'oxygène.

7. Procédé selon l'une des revendications précédentes, **caractérisé en ce que** le substrat à détourer (4) est en silicium et le plasma de gravure à base d'un mélange de SF6 et d'argon.

8. Procédé selon l'une des revendications précédentes, **caractérisé en ce que** le substrat à détourer (4) est recouvert d'une couche d'oxyde de silicium (40) et le plasma de gravure à base d'un mélange de CHF₃ et d'azote.

9. Procédé selon l'une des revendications précédentes, **caractérisé par le fait que** le substrat à détourer (4) est en silicium recouvert d'une couche d'oxyde de silicium (40) et en ce que l'on effectue successivement la gravure de la couche d'oxyde de silicium (40) puis la gravure d'une épaisseur de la couche de silicium.

10. Procédé selon l'une des revendications précédentes, **caractérisé en ce que** le substrat à détourer (4) comprend une zone de fragilisation (44) qui s'étend dans un plan parallèle ou sensiblement parallèle à sa face avant (41) et **en ce que** la gravure partielle du matériau de protection (6) est conduite de façon que le diamètre extérieur de l'anneau (60) de matériau de protection ainsi formé soit inférieur ou égal à celui de la zone plane non chanfreinée (410) de ladite face avant (41), de façon à graver le matériau constituant ledit substrat à détourer sur une largeur correspondant au moins à la totalité de ladite zone chanfreinée.

11. Procédé selon les revendications 3 et 10, **caractérisé en ce que** le diamètre de l'isolant supérieur (53) est inférieur ou égal à celui de la zone plane non chanfreinée (410) de la face avant (41) du substrat à détourer.

12. Procédé selon l'une des revendications précédentes, **caractérisé en ce que** le substrat à détourer (4) comprend une zone de fragilisation (44) qui s'étend dans un plan parallèle ou sensiblement parallèle à sa face avant (41) et **en ce qu'**il est gravé sur une épaisseur correspondant à celle de ladite zone de fragilisation.

13. Procédé de fabrication d'un substrat destiné à des applications dans le domaine de l'électronique, l'optique ou l'optoélectronique, **caractérisé en ce qu'**il comprend les étapes suivantes :
- former une zone de fragilisation (44) à l'intérieur d'un substrat donneur (4), de façon à y délimiter une couche à transférer (441) du reste (442) du substrat,
- soumettre ce substrat donneur (4) à un procédé de détourage selon l'une quelconque des revendications précédentes,
- coller par adhésion moléculaire le substrat donneur ainsi détouré, sur un substrat receveur (7),
- effectuer un traitement de détachement de ladite couche à transférer (441) le long de ladite zone de fragilisation (44), de façon à la transférer sur ledit substrat receveur (7).

14. Procédé selon la revendication 13, **caractérisé en ce que** ladite zone de fragilisation (44) est formée par implantation d'espèces atomiques et/ou ioniques.
